Europäisches Patentamt

(19) European Patent Office

Office européen des brevets

(11) Numéro de publication: **0 163 332**
**B1**

(12) **FASCICULE DE BREVET EUROPEEN**

(45) Date de publication du fascicule du brevet: **22.08.90**

(21) Numéro de dépôt: **85200635.2**

(22) Date de dépôt: **24.04.85**

(51) Int. Cl.⁵: **H 03 K 17/18,** H 03 K 17/60, H 03 K 17/08

(54) Relais statique pour courant continu.

(30) Priorité: **11.05.84 FR 8407309**

(43) Date de publication de la demande: **04.12.85 Bulletin 85/49**

(45) Mention de la délivrance du brevet: **22.08.90 Bulletin 90/34**

(84) Etats contractants désignés: **DE FR GB IT**

(56) Documents cités:
**DE-A-2 120 865**
**US-A-3 736 469**
**US-A-3 978 350**

**PATENTS ABSTRACTS OF JAPAN, vol. 8, no. 74 (E-236) 1511r, 6 avril 1984; & JP - A - 58 222 555 (NISSAN JIDOSHA K.K.) 24-12-1983**

(73) Titulaire: **PHILIPS COMPOSANTS 117, quai du Président Roosevelt F-92130 Issy les Moulineaux (FR)**

㊙ **FR**

(73) Titulaire: **N.V. Philips' Gloeilampenfabrieken Groenewoudseweg 1 NL-5621 BA Eindhoven (NL)**

㊙ **DE GB IT**

(72) Inventeur: **Stroppiana, Robert SOCIETE CIVILE S.P.I.D. 209 rue de l'Université F-75007 - Paris (FR)**

(74) Mandataire: **Jacquard, Philippe et al Société Civile S.P.I.D. 156, Boulevard Haussmann F-75008 Paris (FR)**

Courier Press, Leamington Spa, England.

## Description

La présente invention concerne un relais statique pour courant continu notamment sous basse tension, destiné à l'alimentation d'une charge, comprenant un transistor bipolaire de sortie d'un premier type de conductivité dont le collecteur est connecté à une borne de sortie destinée à alimenter la charge, laquelle est reliée par ailleurs à un pôle commun d'alimentation, dont l'émetteur est relié à une borne d'alimentation destinée à être connectée à l'autre pôle de ladite alimentation, le transistor de sortie étant bloqué ou passant selon le signal appliqué sur sa base et comportant un transistor bipolaire également du premier type de conductivité dit premier transistor de contrôle dont le trajet émetteur-base est connecté en parallèle sur le trajet base émetteur du transistor bipolaire de sortie et un second transistor de contrôle dont une première électrode est connectée au collecteur du premier transistor de contrôle et une deuxième électrode au collecteur du transistor de sortie.

Un tel relais statique est connu de US—A—3 736 469 en tant que circuit de protection contre les surcharges d'un régulateur de tension. Le deuxième transistor de contrôle a son émetteur relié au collecteur du premier transistor de contrôle un dispositif à diodes permettant de faire varier le seuil et sa base au collecteur du transistor de sortie. Il ne permet que la discrimination d'un état de court-circuit.

Un relais statique peut être utilisé notamment dans le domaine des installations électriques des véhicules automobiles, application dans laquelle il est susceptible de remplacer avantageusement les systèmes classiques à relais électromagnétiques. Un relais statique peut notamment être utilisé pour le cas des installations électriques des véhicules automobiles pour lesquelles les diverses ampoules doivent être alimentées par des transistors de commande à la tension nominale de la batterie. Dans ce cas, il est souhaitable de pouvoir discriminer des anomalies relatives à la charge, à savoir non connexion, ou mise en court-circuit de celle-ci, et selon des modes préférés, contre des anomalies relatives à l'alimentation électrique du relais.

L'invention concerne ainsi un dispositif du type précité et dont le second transistor de contrôle est à effet de champ MOS à enrichissement et à canal du second type de conductivité dont le drain constitue ladite première électrode, dont la grille constitue ladite deuxième électrode, de telle sorte qu'un signal représentatif de l'état de la charge est produit par la source du second transistor de contrôle, et en ce que le premier transistor de contrôle présente une résistance de base supplémentaire.

Le relais selon l'invention peut être réalisé sous forme de circuit intégré.

Selon une variante préférée, un signal de comamnde est appliqué sur la grille d'un transistor de commande et le signal de contrôle obtenu à partir du collecteur du transistor de contrôle est directement utilisé pour réaliser un auto-entretien du relais.

Le relais comporte à cet effet un transistor de commande à effet de champ MOS à enrichissement et à canal du second type de conductivité dont la source est reliée à une borne de pôle commun, dont le drain est relié à la base du transistor de sortie par l'intermédiaire d'une résistance de limitation de courant et dont la grille est commandée à partir d'une borne de commande et est reliée d'une part à la borne de mode commun par une résistance d'auto-entretien et d'autre part à la source du second transistor de contrôle de manière à appliquer sur la grille du transistor de commande une tension d'auto-entretien dans l'état normal de la charge.

Selon un mode de réalisation, le relais fournit un signal de contrôle selon un état logique. Le relais comporte à cet effet un transistor de verrouillage, à enrichissement et à canal du second type de conductivité dont le trajet drain-source est branché en parallèle sur la résistance d'auto-entretien, et dont la grille est reliée à ladite borne de commande et, un circuit logique formé de deux transistors de contrôle MOS à effet de champ en série, à enrichissement et dont le type de canal est opposé l'un par rapport à l'autre, le premier ayant sa grille reliée à la borne de commande et le second ayant sa grille reliée au drain du transistor de commande de manière à transmettre vers une borne logique de contrôle un signal de contrôle à deux états.

Le relais peut également être commandé par tout ou rien grâce à un circuit générateur d'impulsion calibrée comportant une première, et une deuxième résistance, chacune ayant une électrode connectée à la borne d'alimentation, et son autre électrode étant reliée respectivement à une électrode d'un condensateur, l'électrode commune au condensateur et à la deuxième résistance étant reliée à la grille d'un transistor à effet de champ MOS à enrichissement et à canal du premier type de conductivité dans la source est reliée à la borne d'alimentation et la drain à la grille du transistor de commande, le point commun au condensateur et à la première résistance étant relié à la borne de commande de telle sorte que, lorsque la borne de commande est mise à la masse, le circuit générateur d'impulsion produise une impulsion de mise en marche.

Selon un mode de réalisation, le premier transistor du circuit logique a un canal du premier type de conductivité, et a son drain connecté à la borne logique de contrôle, et sa source à celle du second transistor dont le drain est reliée à la borne d'alimentation.

Selon une variante avantageuse, la borne de commande est attaquée par un transistor de commande logique à effet de champ MOS à enrichissement dont le trajet drain-source est branché entre la borne de pôle commun et la borne de commande de telle sorte que sa grille reçoive une commande logique par exemple TTL, permettant ladite mise à la masse de la borne de commande.

L'auto-entretien de relais peut être également réalisé en mettant en oeuvre une seconde résistance d'auto-entretien disposée entre la source du second transistor de contrôle et l'électrode non à la masse de la première résistance d'auto-entretien, de manière à former avec celle-ci au pont diviseur.

L'invention sera mieux comprise à la lecture de la description qui va suivre, donnée à titre d'exemple non limitatif en liaison avec les figures qui représentent:

—la figure 1, un schéma d'un relais selon l'invention;

—la figure 2, une échelle des tensions recueillies à la borne C de la figure 1, selon les divers états de la charge;

—la figure 3, une variante de l'invention avec auto-entretien du relais;

—la figure 4, une variante de la figure 3 délivrant un signal logique de contröle.

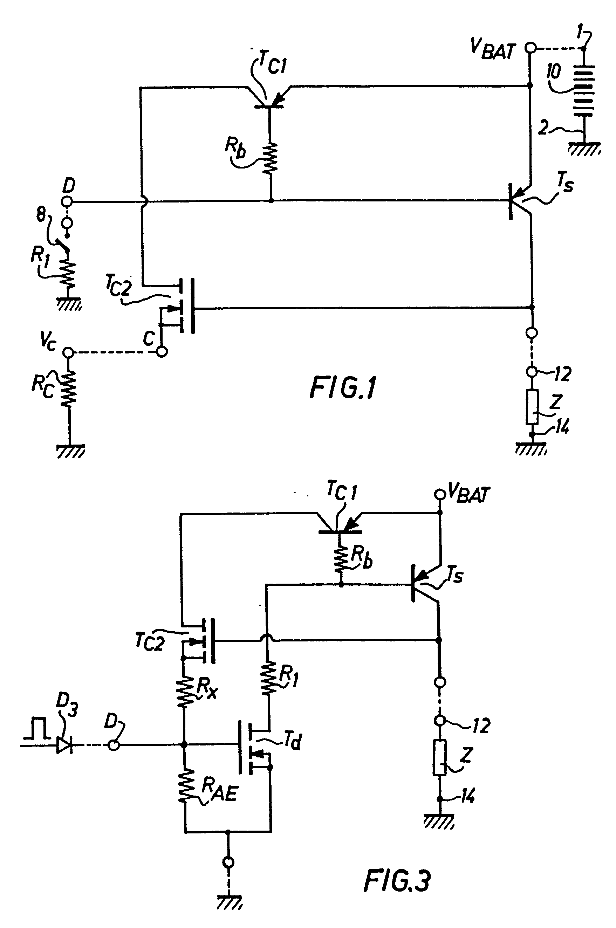

Sur la figure 1, un transistor bipolaire Ts PNP, dit de type P, a son trajet émetteur-collecteur inséré entre une première borne 1 d'une alimentation 10 et une première connection 12 d'une charge Z, l'autre borne 2 de l'alimentation et l'autre connexion 14 de la charge étant reliées l'une et l'autre à un pôle de mode commun. L'alimentation 10 est une alimentation continue à basse tension, dont la tension $V_{bat}$ a une valeur de 12 volts per exemple dans le cas d'une batterie.

Le transistor de sortie Ts est commandé de manière classique par l'intermédiaire de sa base reliée à une borne de commande D. Un interrupteur 8 extérieur au circuit permet de relier la borne de commande D à une extrémité d'une résistance $R_1$ dont l'autre extrémité est connectée au pôle de mode commun. La fermeture de l'interrupteur 8 entraîne le passage à l'état passant du trajet émetteur-collecteur du transistor de sortie Ts et l'alimentation de la charge Z. Un premier transistor de contrôle $T_{c1}$ bipolaire également de type p a son trajet émetteur-base relié en parallèle au trajet émetteur-base du transistor de sortie Ts, c'est-à-dire que l'émetteur du transistor $T_{c1}$ est relié à celui du transistor Ts et à la borne d'alimentation $V_{bat}$, et que la base du transistor $T_{c1}$ dans laquelle est disposée une résistance de base $R_b$ est reliée à la base du transistor de sortie Tc.

Le collecteur du premier transistor de contrôle $T_{c1}$ est connecté au drain d'un second transistor de contrôle $T_{c2}$ à effet de champ MOS à enrichissement et à canal n, dont la grille est connectée au collecteur du transistor de sortie Ts et la source à une borne de contrôle C. Lorsque cette dernière est chargée par une résistance Rc disposée entre la borne C et la masse, la borne C délivre une tension Vc représentative de l'état de la charge Z.

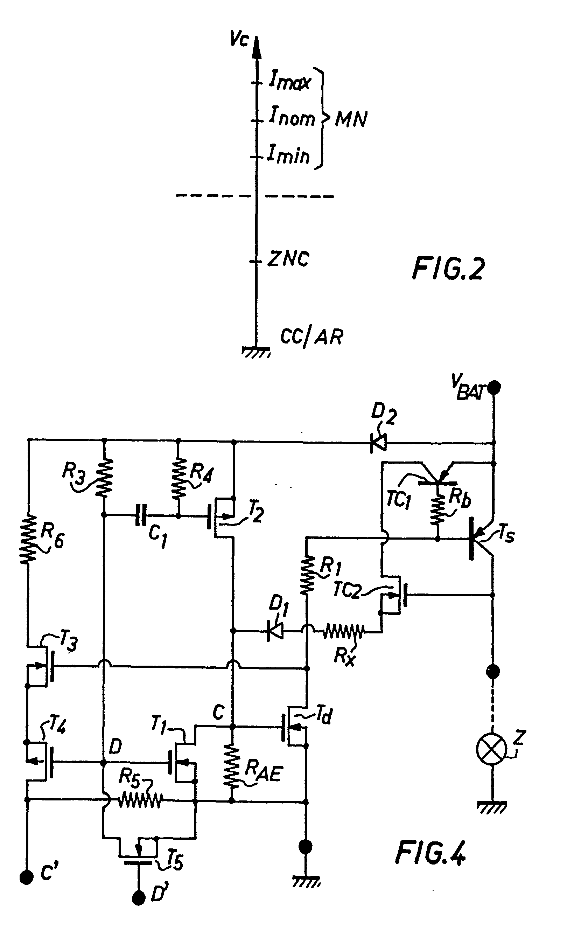

Un diagramme des diverses valeurs significatives de la tension Vc est représenté à la figure 2.

En cas de marche normale du relais (MN), le collecteur du transistor de sortie Ts débite dans la charge Z un courant compris entre une valeur minimale $I_{min}$ et une valeur maximale $I_{max}$,

laquelle correspond à l'appel de courant à l'allumage quand la charge Z est une lampe, par exemple d'un phare d'automobile, ou bien une charge inductive. En régime établi, le courant est stabilisé à une valeur nominale $I_{nom}$.

Lorsque le relais est commandé (interrupteur 8 fermé), et que l'état de la charge est normal ($I_{min} < I < I_{max}$) la tension $V_c$ s'établit à une valeur d'autant plus élevée que I est plus proche de $I_{max}$. Ceci est dû au fait que le collecteur du transistor $T_{c1}$ délivre dans $R_c$ un courant qui croît en fonction du courant I, ce courant traversant le trajet drain-source du second transistor de contrôle $T_{c2}$ qui est passant du fait que la grille de $T_{c2}$ est au potentiel du collecteur du transistor de sortie Ts, voisin de $V_{bat}$.

Dans le cas où la charge n'est pas connectée (ZNC), le collecteur de Ts ne débite pas de courant, et son potentiel reste à un niveau élevé, ce qui fait que le second transistor de contrôle $T_{c2}$ reste à l'état passant. Le collecteur du premier transistor de contrôle $T_{c1}$ délivre dans $R_c$ un courant faible, ce qui génère sur la borne de commande C une tension $V_c$ très inférieure à celle recueillie en cas de fonctionnement normal.

Dans le cas où la charge Z est court-circuitée (CC), la grille du second transistor de contrôle $T_{c2}$ est au potentiel nul, ce qui induit le blocage de ce dernier. De ce fait, le potentiel Vc est également nul.

Dans le cas où le relais n'est pas actionné (AR), on retrouve la même configuration que dans le cas précédente. Le courant dans le collecteur du transistor de sortie Ts étant nul, la grille du second transistor de contrôle $T_{c2}$ est au potentiel nul, et le potentiel Vc est nul.

En résumé, lorsque le relais est en état de marche normale, on recueille à la borne de contrôle C une tension Vc située dans une gamme élevée, alors que l'arrêt du relais ou les incidents de fonctionnement induisent sur celle-ci des tensions Vc faibles ou nulles.

Selon la figure 3, le relais est autoentretenu. On utilise à cet effet le signal disponible à la source du second transistor de contrôle $T_{c2}$.

Le signal impulsionnel envoyé sur la borne de commande D à travers une diode d'isolement D3 est reçu par la grille d'un transistor de commande Td à effet de champ MOS à enrichissement et à canal n dont le drain, à son tour, est relié à la base du transistor de sortie Ts à travers la résistance $R_1$. Le relais étant autoentretenu, il peut être commandé par une impulsion. Cette impulsion a une durée suffisante pour forcer la commande pendant la montée du courant dans la charge Z. La source du transistor Td est connectée à la masse, ce qui fait que tant que le transistor de commande Td est passant, la résistance $R_1$ est connectée entre la base de Ts et la masse.

La source du second transistor de contrôle $T_{c2}$ est reliée à la borne de commande D. L'auto-entretien du relais est obtenu grâce à une résistance dit d'auto-entretien $R_{AE}$ disposée entre la grille du transistor de comamnde Td et la masse.

A titre d'exemple, si on réalise le relais sous forme intégrée monolithique, il convient de noter que le transistor Tc1 sera en général un transistor latéral de gain inférieur ou égal à 30. Dans un tel cas, une résistance $R_b$ de l'ordre de 1 kΩ est convenable.

La valeur de $R_b$ une fois fixée, le réglage de l'auto-entretien est obtenu en jouant sur la valeur de $R_{AE}$, de manière que, dès que la tension de la borne D approche celle correspondant à la condition de charge non connectée, le transistor de commande Td soit désamorcé. Une résistance $R_x$ de faible valeur peut également être disposée en série entre $R_{AE}$ et la source de Tc2.

Le mode de réalisation de la figure 4 permet de commande le relais à l'aide d'un niveau logique appliqué sur la grille d'un transistor $T_5$ à effet de champ MOS du type à enrichissement et à canal n. Il comporte un générateur d'impulsion calibrée comprenant deux résistances $R_3$ et $R_4$ ayant une électrode commune connectée à la source d'alimentation $V_{bat}$, leur autre électrode étant connectée respectivement à chacune des électrodes d'un condensateur $C_1$, par exemple la capacité interne d'un transistor MOS intégré. La borne commune au condensateur $C_1$ et à la résistance $R_4$ est reliée à la grille d'un transistor $T_2$ à effet de champ MOS du type à enrichissement et à canal p, dont la source est alimentée à la tension $V_{bat}$, et le drain qui constitue la sortie du générateur d'impulsion est relié à la grille du transistor de commande Td. La borne commune au condensateur $C_1$ et à la résistance $R_3$ est reliée à la borne de commande D. Lorsque celle-ci est mise à la masse par déblocage du transistor $T_5$, la grille du transistor $T_2$ se trouve momentanément au potentiel nul, et le condensateur $C_1$ dont une électrode est à la masse, se charge à travers $R_4$ avec une constante de temps $R_4 C_1$. Le transistor $T_2$ se trouve donc avoir son trajet source-drain passant tant que son potentiel de grille n'est pas remonté à un niveau suffisant, ce qui se produit au bout d'un temps donné par charge du condensateur $C_1$. On recueille de ce fait une impulsion sur le drain de $T_2$ alimentant la grille du transistor de commande Td de manière à débloquer celui-ci. L'espace grille-drain de $T_2$ remplit la fonction d'isolement de la diode $D_3$ de la figure 3. Après disparition de l'impulsion sur le drain de $T_2$, le relais est auto-entretenu comme dans le cas de la figure 3.

Un transistor de verrouillage $T_1$ à effet de champ MOS à enrichissement et à canal n a son trajet drain-source connecté aux bornes de la résistance d'auto-entretien $R_{AE}$, sa source étant reliée à la masse. La grille du transistor $T_1$ est reliée à la borne de commande D. Lorsque le transistor $T_5$ est bloqué, la grille du transistor $T_1$ est à un potentiel élevé et le transistor de verrouillage $T_1$ court-circuite la résistance d'auto-entretien $R_{AE}$, ce qui met la grille du transistor de commande Td à la masse d'ou résulte la désactivation du relais. Par contre, lorsque le transistor $T_5$ est débloqué, la grille du transistor de verrouillage $T_1$ est à la masse et la résistance $R_{AE}$ n'est plus court-circuitée.

Le circuit de la figure 4 présente également une borne logique de contrôle C' commandée par un circuit logique de contrôle à deux transistors $T_3$ et $T_4$ à effet de champ MOS à enrichissement dont les canaux sont de types opposés. Le transistor $T_3$ à canal n, a son drain relié à la tension d'alimentation $V_{bat}$ par l'intermédiaire d'une résistance de polarisation $R_6$, sa grille au drain du transistor de commande Td et sa source à celle du transistor $T_4$ à canal p dont la grille est connectée à la borne de commande D, et le drain qui constitue la borne logique de contrôle C', à la borne de pôle commun par l'intermédiaire d'une résistance $R_5$ de division de manière à être compatible avec des niveaux logiques (par exemple TTL). La borne logique C' fonctionne selon la table de vérité suivante:

| | |
|---|---|
| Arrêt ($T_5$ bloqué) | 0 |
| Marche ($T_5$ passant) | 0 |
| Marche+ZNC | 1 |
| Marche+CC | 1 |

Le circuit de la figure 4 est commandé par une borne logique de commande D' reliée à la grille du transistor logique $T_5$, à effet de champ MOS du type à enrichissement.

Si, comme représenté, celui-ci est à canal n, sa source étant à la masse et son drain relié à la borne de commande D, un 1 logique sur la grille du transistor $T_5$ rend son trajet drain-source conducteur et provoque la mise en marche du relais. Si le transistor $T_5$ est à canal p, avec sa source reliée à la borne de commande D, et son drain à la masse, la commande s'effectue sur la borne logique D' selon une logique inverse.

Une diode $D_2$ disposée entre la borne d'alimentation $V_{bat}$ et la source de $T_2$ et dans le sens passant lorsque la tension d'alimentation est branchée correctement permet de protéger le relais en cas d'inversion accidentelle de la tension d'alimentation $V_{bat}$.

Selon une variante fonctionnant selon une logique inverse, on prélève le signal logique du circuit logique de contrôle sur le drain de $T_3$, qui n'est plus relié à $V_{bat}$, le drain de $T_4$ étant pour sa part relié à la masse.

**Revendications**

1. Relais statique pour courant continu, destiné à l'alimentation d'une charge (Z), comprenant un transistor bipolaire de sortie (Ts) d'un premier type de conductivité (p) dont le collecteur est connecté à une borne de sortie destinée à alimenter la charge (Z), laquelle est reliée par ailleurs à un pôle commun d'alimentation, dont l'émetteur est relié à une borne d'alimentation destinée à être connectée à l'autre pôle de ladite alimentation, le transistor de sortie étant bloqué ou passant selon le signal appliqué sur sa base, et comportant un transistor bipolaire également du premier type de conductivité dit premier transistor de contrôle (T$_{c1}$) dont le trajet émetteur-base est connecté en parallèle sur le trajet émetteur-base du transistor bipolaire de sortie (Ts), et un second transistor de contrôle (T$_{c2}$), dont une première électrode est connectée au collecteur du premier transistor de contrôle (T$_{c1}$) et une deuxième électrode au collecteur du transistor de sortie (Ts) caractérisé en ce que le second transistor de contrôle (T$_{c2}$) est à effet de champ MOS à enrichissement et à canal du second type de conductivité (n) dont le drain constitue ladite première électrode et la grille constitue ladite deuxième électrode, de telle sorte qu'un signal représentatif de l'état de la charge (Z) est produit par la cource du second transistor de contrôle (T$_{c2}$), et en ce que le premier transistor de contrôle (T$_{c1}$) présente une résistance de base supplémentaire (R$_b$).

2. Relais statique selon la revendication 1, caractérisé en ce qu'il comporte un transistor de commande (T$_d$) à effet de champ MOS à enrichissement et à canal du second type de conductivité (n), dont la source est reliée à une borne de pôle commun, dont le drain est relié à la base du transistor de sortie (Ts) par l'intermédiaire d'une résistance de limitation de courant (R$_1$), et dont la grille est commandée à partir d'une borne de commande (D) et est reliée d'une part à la borne de mode commun par une résistance d'auto-entretien (R$_{AE}$) et d'autre part à la source du second transistor de contrôle (T$_{c2}$), de manière à appliquer sur la grille du transistor de commande (T$_d$) une tension d'auto-entretien dans l'état normal de la charge (Z).

3. Relais statique selon la revendication 2, caractérisé en ce qu'il comporte un transistor de verrouillage (T$_1$), à effet de champ MOS à enrichissement et à canal du second type (n) dont le trajet drain-source est branché en parallèle sur la résistance d'auto-entretien (R$_{AE}$), et dont la grille est reliée à ladite borne de commande (D), et un circuit logique formé de deux transistors de contrôle MOS à effet de champ en série, à enrichissement et dont le type de canal est opposé l'un par rapport à l'autre, le premier (T$_4$) ayant sa grille reliée à la borne de commande et le second (T$_3$) ayant sa grille reliée au drain du transistor de commande (Td) de manière à produire sur une borne logique de contrôle (C') un signal de contrôle à deux états.

4. Relais statique selon la revendication 3, caractérisé en ce qu'il comporte un circuit générateur d'impulsion calibrée comprenant une première et une deuxième résistance (R$_3$, R$_4$) chacune ayant une électrode connectée à la borne d'alimentation (V$_{bat}$), et son autre électrode étant reliée respectivement à une électrode d'un condensateur (C$_1$), l'électrode commune au condensateur (C$_1$) et à la deuxième résistance (R$_4$) étant reliée à la grille d'un transistor à effet de champ MOS à enrichissement et à canal du premier type de conductivité (p) dont la source est reliée à la borne d'alimentation (V$_{bat}$) et le drain à la grille du transistor de commande (T$_d$), le point commun un condensateur (C$_1$) et à la première résistance (R$_3$) étant relié à la borne de commande (D) de telle sorte que, lorsque la borne de commande (D) est mise à la masse, le circuit générateur d'impulsion produise une impulsion de mise en marche.

5. Relais statique selon une des revendications 3 ou 4, caractérisé en ce que le premier transistor (T$_4$) du circuit logique a un canal du premier type de conductivité (p), et a son drain connecté à la borne logique de contrôle C' et sa source à celle du second transistor (T$_3$) dont le drain est connecté à la borne d'alimentation (V$_{bat}$).

6. Relais statique selon une des revendication 3 à 5, caractérisé en ce que la borne de commande est attaquée par un transistor de commande logique (T$_5$) à effet de champ MOS à enrichissement dont le trajet drain-source est branché entre la borne de pôle commun et la borne de commande (D) de telle sorte que sa grille reçoive un commande logique (TTL) permettant ladite mise à la masse de la borne de commande (D).

7. Relais statique selon une des revendications 3 à 6, caractérisé en ce qu'il comporte une seconde résistance d'auto-entretien (R$_x$) disposée entre la source du second transistor de contrôle (T$_{c2}$) et l'électrode non à la masse de la première résistance d'auto-entretien (R$_{AE}$), de manière à former avec celle-ci un pont diviseur.

**Patentansprüche**

1. Statisches Gleichstromrelais zum Speisen einer Belastung (Z), mit einem bipolaren Ausgangstransistor (Ts) von einem ersten Leitfähigkeitstyp (p), dessen Kollektor mit einer Ausgangsklemme zum Speisen der Belastung (Z) verbunden ist, die außerdem an einen gemeinsamen Speisepol angeschlossen ist, dessen Emitter an eine Spieseklemme zum Verbinden mit dem anderen Pol der Speisung angeschlossen ist, wobei der Ausgangstransistor gemäß dem seiner Basis zugeführten Signal nichtleitend oder leitend ist, und mit einem bipolaren Transistor ebenfalls vom ersten Leitfähigkeitstyp mit der Bezeichnung von erstem Steuertransistor (T$_{c1}$), dessen Emitter-Basisstrecke zur Emitter-Basisstrecke des bipolaren Ausgangstransistors (Ts) parallel geschaltet ist, und mit einem zweiten Steuertransistor (T$_{c2}$), von dem eine erste Elektrode mit dem Kollketor des ersten Steuertransistors (T$_{c1}$) und eine zweite Elektrode mit dem Kollektor des Ausgangstransistors (Ts) verbunden sind, dadurch gekennzeichnet, daß der zweite Steuertransistor (T$_{c2}$) ein MOS-Fet vom Anreicherungstyp mit einem Kanal vom zweiten Leitfähigkeitstyp (n) ist, dessen Abzug die erste Elektrode und das Gate die zweite Elektrode derart bilden, daß ein den Zustand der Belastung (Z) darstellendes Signal von der Quelle des zweiten Steuertransistors (T$_{c2}$) ausgegeben wird, und daß der erste Steuertransistor (T$_{c1}$) einen zusätzlichen Basiswiderstand (R$_b$) enthält.

2. Statisches Relais nach Anspruch 1, dadurch gekennzeichnet, daß ein MOS-Fet-Treibertransistor (T$_d$) vom Anreicherungstyp mit einem Kanal vom zweiten Leitfähigkeitstyp (n) vorgesehen ist, dessen Quelle an eine gemeinsame Polklemme und dessen Abzug an die Basis des Ausgangstransistors (Ts) über einen Strombegrenzungswiderstand (R$_1$) angeschlossen sind, und dessen Gate von einer Treiberklemme (D) getrieben wird und einerseits über einen selbsthaltenden Widerstand (R$_{AE}$) an eine Gleichtaktklemme und andererseits an die Quelle des zweiten Steuertransistors (T$_{c2}$) derart angeschlossen ist, daß dem Gate des Treibertransistors (T$_d$) im normalen Zustand der Belastung (Z) eine Selbsthaltespannung zugeführt wird.

3. Statisches Relais nach Anspruch 2, dadurch gekennzeichnet, daß ein MOS-Fet-Verriegelungstransistor (T$_1$) vom Anreicherungstyp mit einem Kanal vom zweiten Leitfähigkeitstyp (n), dessen Abzug/Quellenstrecke parallel zum selbsthaltenden Widerstand (R$_{AE}$) abgezweigt und dessen Gate an die Treiberklemme (D) angeschlossen ist, und eine logische Schaltung aus zwei reihengeschalteten MOS-Fet-Steuertransistoren (T$_1$) vom Anreicherungstyp mit entgegengesetzten Kanaltypen vorgesehen sind, wobei das Gate des ersten Transistors (T$_4$) mit der Treiberklemme und das Gate des zweiten Transistors (T$_3$) mit dem Abzug des Treibertransistors (T$_d$) derart verbunden sind, daß an einer logischen Steuerklemme (C') ein Steuersignal mit zwei Zuständen erzeugt wird.

4. Statisches Relais nach Anspruch 3, dadurch gekennzeichnet, daß eine Generatorschaltung für geeichte Impulse mit einem ersten und einem zweiten Widerstand (RF$_3$, R$_4$) vorgesehen ist, wobei jeder Widerstand mit einem Elektrode an die Speiseklemme (V$_{bat}$) und mit der anderen Elektrode in Verbindung mit einer Elektrode eines Kondensators (C$_1$) sowie in Verbindung mit der dem Kondensator (C$_1$) und dem zweiten Widerstand (R$_4$) gemeinsamen Elektrode versehen ist, die mit dem Gate eines MOS-Fet-Transistors vom Anreicherungstyp mit einem Kanal vom Leitfähigkeitstyp (p) verbunden ist, dessen Quelle an die Speiseklemme (V$_{bat}$) und der Abzug an das Gate des Treibertransistors (T$_d$) angeschlossen sind, der dem Kondensator (C$_1$) und dem ersten Widerstand (R$_3$) derart mit der Treiberklemme (D) verbunden sind, daß bei einer Massenverbindung der Treiberklemme (D) die Impulsgeberschaltung einen Startimpuls erzeugt.

5. Statisches Relais nach einem der Ansprüche 3 oder 4, dadurch gekennzeichnet, daß der erste Transistor (T$_4$) der logischen Schaltung einen Kanal vom ersten Leitfähigkeitstyp (p) besitzt, mit seinem Abzug an die logische Steuerklemme (C') und mit seiner Quelle an die des zweiten Transistors (T$_3$) angeschlossen sind, dessen Abzug mit der Speiseklemme (V$_{bat}$) verbunden ist.

6. Statisches Relais nach einem der Ansprüche 3 bis 5, dadurch gekennzeichnet, daß die Treiberklemme von einem logischen MOS-Fet-Treibertransistor (T$_5$) vom Anreicherungstyp angesteuert wird, dessen Abzug/Quellenstrecke zwischen der gemeinsamen Polklemme und der Treiberklemme (D) derart abgezweigt wird, daß bei seinem Gate ein logischer Befehl (TTL) ankommt, der die Massenverbindung der Treiberklemme (D) ermöglicht.

7. Statisches Relais nach einem der Ansprüche 3 bis 6, dadurch gekennzeichnet, daß ein zweiter Selbsthaltewiderstand zwischen der Quelle des zweiten Steuertransistors (T$_{c2}$) und der nicht an Masse liegenden Elektrode des ersten Selbsthaltewiderstandes (R$_{AE}$) derart vorgesehen ist, daß damit eine Teilerbrücke gebildet wird.

**Claims**

1. A static relay for direct current to be supplied to a load (Z), comprising a bipolar output transistor (T$_s$) of a first conductivity type (p), whose collector is connected to an output terminal for supplying the load (Z), which is further connected to a common supply terminal, whose emitter is connected to a supply terminal which is to be connected to the other pole of the said supply, the output transistor being blocked or driven into conduction according to the signal applied to its base, and comprising a bipolar transistor also of the first conductivity type and referred to as first detection transistor (T$_{c1}$) whose emitter-base path is connected in parallel to the emitter-base path of the bipolar output transistor (T$_s$), and a second detection transistor (T$_{c2}$), of which a first electrode is connected to the collector of the first detection transistor (T$_{c1}$) and a second electrode to the collector of the output transistor (T$_s$), characterized in that the second detection transistor (T$_{c2}$) is a MOS field effect transistor of the enhancement type having a channel of the second conductivity type (n), whose drain constitutes the said first electrode and whose gate constitutes the said second electrode in a manner such that a signal representative of the state of the load (Z) is produced by the source of the second detection transistor (T$_{c2}$), and in that the first detection transistor (T$_{c1}$) provides an additional base resistance (R$_b$).

2. A static relay as claimed in Claim 1, characterized in that it comprises a MOS field effect control transistor (T$_d$) of the enhancement type having a channel of the second conductivity type (n), whose source is connected to the common connection terminal, whose drain is connected to the base of the output transistor (T$_s$) through a current limiting resistor (R$_1$) and whose gate is controlled via a control terminal (D) and is connected on the one hand to the common connection terminal through a self-maintenance resistor (R$_{AE}$) and on the other hand to the source of the second detection transistor (T$_{c2}$) in a manner such that a self-maintenance voltage is applied to the gate of the control transistor (T$_d$) in the normal state of the load (Z).

3. A static relay as claimed in Claim 2, characterized in that it comprises a MOS field effect locking transistor (T$_1$) of the enhancement type having a channel of the second type (n), whose drain-source path is connected in parallel to the self-maintenance resistor ($R_{AE}$) and whose gate is connected to the said control terminal (D), and a logic circuit formed by two series-connected MOS field effect detection transistors of the enhancement type having channels of opposite types, the first transistor ($T_4$) having its gate connected to the control terminal and the second transistor ($T_3$) having its gate connected to the drain of the control transistor ($T_d$) in a manner such that a detection signal having two states is produced at a logic detection terminal (C').

4. A static relay as claimed in Claim 3, characterized in that it comprises a calibrated pulse generator circuit comprising a first and a second resistor ($R_3$, $R_4$) each having an electrode connected to the supply terminal ($V_{bat}$), their other electrodes being connected to respective electrodes of a capacitor ($C_1$), while the electrode common to the capacitor ($C_1$) and to the second resistor ($R_4$) is connected to the gate of a MOS field effect transistor of the enhancement type having a channel of the first conductivity type (p), whose source is connected to the supply terminal ($V_{bat}$) and whose drain is connected to the gate of the control transistor ($T_d$), the junction between the capacitor ($C_1$) and the first resistor ($R_3$) being connected to the control terminal (D) in a manner such that, when the control terminal (D) is connected to ground, the pulse generator circuit produces an activating pulse.

5. A static relay as claimed in any one of Claims 3 or 4, characterized in that the first transistor ($T_4$) of the logic circuit has a channel of the first conductivity type (p) and has its drain connected to the logic detection terminal (C') and has its source connected to that of the second transistor ($T_3$), whose drain is connected to the supply terminal ($V_{bat}$).

6. A static relay as claimed in any one of Claims 3 to 5, characterized in that the control terminal is acted upon by a logic MOS field effect control transistor ($T_5$) of the enhancement type, whose drain-source path is connected between the common connection terminal and the control terminal (D) in a manner such that its gate receives a logic control signal (TTL) permitting the control terminal (D) to be connected to ground.

7. A static relay as claimed in any one of Claims 3 to 6, characterized in that it comprises a second self-maintenance resistor ($R_x$) arranged between the source of the second detection transistor ($T_{c2}$) and the non-grounded electrode of the first self-maintenance resistor ($R_{AE}$) in a manner such that it forms with the latter a voltage divider.

FIG.1

FIG.3

EP 0 163 332 B1

FIG.2

FIG.4